# EUROPEAN PATENT APPLICATION

(11) **EP 4 694 584 A1**
(43) Date of publication of application: **11.02.2026**
(21) Application number: 24850589.3
(22) Date of filing: 28.04.2024
(51) Int. Cl.: H05K 1/11

(54) **CIRCUIT BOARD AND MANUFACTURING METHOD THEREFOR, AND ELECTRONIC DEVICE**

(30) Priority: 09.08.2023 CN 202311003272
(71) Applicant: ZTE Corporation, Shenzhen, Guangdong 518057 (CN)
(72) Inventor: KANG, Xin, Shenzhen, Guangdong 518057 (CN); LI, Jinlong, Shenzhen, Guangdong 518057 (CN); WEI, Zhongmin, Shenzhen, Guangdong 518057 (CN)
(74) Representative: Ziebig Hengelhaupt Intellectual Property Attorneys Patentanwaltskanzlei PartGmbB
(86) International application number: PCT/CN2024/090363
(87) International publication number: WO 2025/030933

(57) **Abstract**

The present application discloses a circuit board and a manufacturing method therefor, and an electronic device. The disclosed circuit board comprises a circuit board body (100) and via hole structures (200); hole sections (101) and back drilling holes (102) communicated with each other are formed in the circuit board body (100); hole openings of the hole sections (101) are located on a first surface of the circuit board body (100); hole openings of the back drilling holes (102) are located on a second surface of the circuit board body (100); the first surface and the second surface are opposite to each other; a metal layer is provided on the inner walls of the hole sections (101) to form the via hole structures (200); the via hole structures (200) are each filled with a first filler (300); and the back drilling holes (102) are each filled with a second filler (400), wherein the dielectric constant of the second filler (400) is less than the dielectric constant of the circuit board body (100).

## Description

### CROSS REFERENCE TO RELATED APPLICATIONS

The present application is based upon and claims priority to Chinese Patent Application No. 202311003272.2, filed on August 09, 2023, entitled "CIRCUIT BOARD AND MANUFACTURING METHOD THEREFOR, AND ELECTRONIC DEVICE", the entire contents of which are incorporated herein by reference.

### TECHNICAL FIELD

The present application relates to the field of circuit board design, and in particular to a circuit board and a manufacturing method therefor, and an electronic device.

### BACKGROUD

With rapid development in the electronic communication industry, communication devices have been much more complex and integrated, and the signal rate has also been increased gradually Products supporting the rate of 112 Gbps have been used commercially, while research and development in products supporting the rate of 224 Gbps becomes urgent. A via serves as a PCB structure necessary for a high-speed and high-density design, and the performance of the via directly affects the performance of high-speed and high-density products. The impedance continuity is one of the important indicators for measuring the performance of the via. Generally, the impedance of via (i.e., via impedance) is much smaller than the characteristic impedance of a PCB transmission line connected thereto, resulting in low impedance continuity of the entire link, and further problems in signal integrity.

In the related art, in order to increase the via impedance, generally the dielectric constant of a circuit board body is reduced, or the stub length is reduced by back drilling. However, when the circuit board body is manufactured from the material with a low dielectric constant, the material with higher grade causes higher cost; or when the manner of reducing the stub length is used, a good effect cannot be achieved due to factors such as the capability of stub processing. Therefore, how to effectively increase the via impedance is a technical problem that needs to be solved at present.

### SUMMARY

In a first aspect, the present application discloses a circuit board including a circuit board body and a via structure; the circuit board body is provided with a hole section and a back drilling hole communicated with each other, a hole opening of the hole section is located in a first surface of the circuit board body, a hole opening of the back drilling hole is located in a second surface of the circuit board body, the first surface and the second surface are opposite to each other, a metal layer is provided on an inner wall of the hole section to form a via structure, the via structure is filled with a first filler, the back drilling hole is filled with a second filler, where a dielectric constant of the second filler is less than a dielectric constant of the circuit board body .

In a second aspect, the present application further discloses an electronic device including a circuit board of the first aspect.

In a second aspect, the present application further discloses a manufacturing method for a circuit board, the circuit board includes a circuit board body, the manufacturing method includes: forming a first through hole in the circuit board body; disposing a metal layer on an inner wall of the first through hole to form a metallized through hole; filling a first filler into the metallized through hole; and back-drilling the metallized through hole on a second surface of the circuit board body to form a back drilling hole, where the metalized through hole after back-drilling forms a via structure.

In a fourth aspect, the present application further discloses a manufacturing method for a circuit board, the circuit board includes a circuit board body, the manufacturing method includes: forming a first through hole in the circuit board body; disposing a metal layer on an inner wall of the first through hole to form a metallized through hole; back-drilling the metallized through hole on a second surface of the circuit board body to form a back drilling hole, where the metallized through hole after back drilling forms a via structure; and filling a first filler into the via structure, and filling a second filler into the back drilling hole, where a dielectric constant of the first filler is equal to a dielectric constant of the second filler and is less than a dielectric constant of the circuit board body.

### BRIEF DESCRIPTION OF THE DRAWINGS

FIG. 1 is a schematic structural diagram of a first circuit board disclosed in embodiments of the present application.
FIG. 2 is a schematic structural diagram of a second circuit board disclosed in embodiments of the present application.
FIG. 3 is a comparison diagram of the via impedance in a circuit board disclosed in embodiments of the present application versus the via impedance in a circuit board in the related art, where the horizontal axis represents time, and the vertical axis represents the impedance value detected by TDR (Time Domain Reflectometry).
FIG. 4 is a comparison diagram of insertion loss and return loss at a via structure in a circuit board disclosed in embodiments of the present application versus those at a via structure in a circuit board in the related art, where the horizontal axis represents frequency, and the vertical axis represents logarithmic amplitude-frequency characteristics.
FIG. 5 is a comparison diagram of insertion loss at a via structure in a circuit board disclosed in embodiments of the present application versus that at a via structure in a circuit board in the related art, where the horizontal axis represents frequency, and the vertical axis represents logarithmic amplitude-frequency characteristics.
FIG. 6 is a flow chart of a manufacturing method for a circuit board disclosed in embodiments of the present application.

List of reference signs:
100-circuit board body, 101-hole section, 102-back drilling hole,
200-via structure,
300-first filler,
400-second filler,
500-circuit layer,
600-shielding layer, 700-pad.

### DETAILED DESCRIPTION

In order to make the purpose, technical solution and advantages of the present application clearer, the technical solution of the present application will be described clearly and thoroughly below with reference to the specific embodiments of the present application and the corresponding drawings. Apparently, the embodiments described herein are merely a part of the embodiments of the present application rather than all of them. All other embodiments that can be obtained by those skilled in the art without creative work based on embodiments in the present application shall fall within the scope of the present application.

The technical solutions disclosed in various embodiments of the present application will be described in detail below with reference to the accompanying drawings.

In common systems, via structures play a critical role in signal interconnection for components such as high-speed connectors, BGAs (Ball Grid Array), as well as differential/single-ended layer transitions on PCBs (Printed Circuit Board). With increase of the signal rate, SI (Signal Integrity) of a system becomes more sensitive to impedance continuity, and the impact of via impedance continuity on channels is particularly significant. Via impedance is influenced by a variety of factors, since the present application primarily targets a signal transmission system operating at 112Gbps and above, and the via impedance in such a system may be either high or low, the present application mainly aims at the scenario with low via impedance.

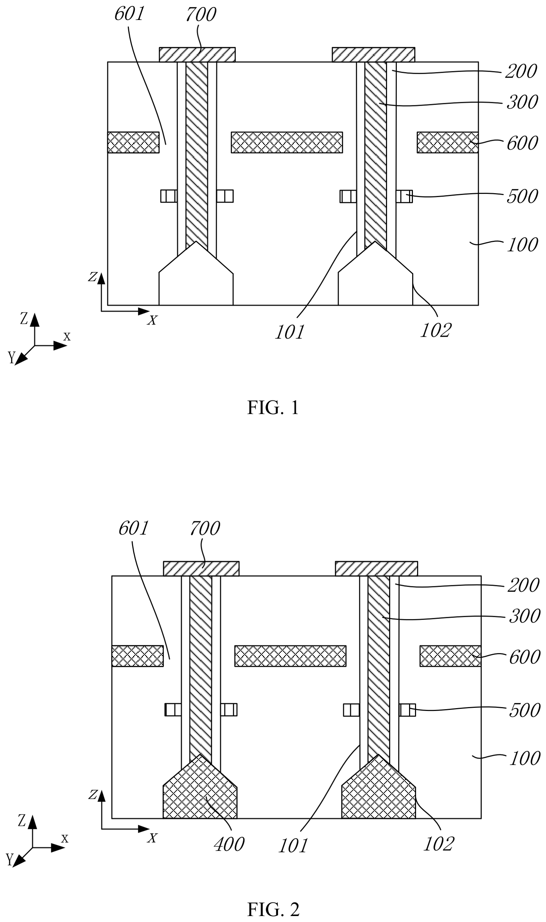

Referring to FIG. 1 to FIG. 6, embodiments of the present application discloses a circuit board, and the disclosed circuit board may be of a multi-layer structure. The disclosed circuit board includes a circuit board body 100 and a via structure 200.

The circuit board body 100 is provided with a hole section 101 and a back drilling hole 102 which are communicated with each other, a hole opening of the hole section 101 is located in a first surface of the circuit board body 100, a hole opening of the back drilling hole 102 is located in a second surface of the circuit board body 100, and the first surface and the second surface are opposite to each other.

A metal layer is disposed on the inner wall of the hole section 101 so as to form the via structure 200. The via structure 200 may be used for signal interconnection of components such as high-speed connectors, BGA as well as differential/single-ended layer transitions on the circuit board body 100.

The via structure 200 is filled with a first filler 300, and the back drilling hole 102 is filled with a second filler 400, where the dielectric constant of the second filler 400 is less than the dielectric constant of the circuit board body 100.

It should be noted that in related art, in order to increase the via impedance, the dielectric constant of the circuit board body is reduced, that is, materials, arrangement, etc., of components arranged in the horizontal direction (directions x and y as shown in FIG. 1 and FIG. 2) are adjusted to increase the via impedance. Therefore, in related art, materials, arrangement, etc., of components arranged in the horizontal direction of the circuit board are adjusted to increase the via impedance.

In the circuit board disclosed in embodiments of the present application, the via impedance is changed by adjusting the materials, arrangement, etc., of components of the circuit board along the through hole direction of the via structure 200 (that is, the direction z in FIG. 1 and FIG. 2). It should be noted that the via impedance mentioned in embodiments of the present application refers to the impedance at the location of the via structure 200 of the circuit board. In the case that the hole section 101 and back drilling hole 102 communicated with each other are formed in the circuit board disclosed in embodiments of the present application, firstly, a first through hole is formed in the circuit board, and a metal layer is disposed on the inner wall of the first through hole so as to form a metallized through hole, then the metallized through hole is back-drilled on the second surface of the circuit board body 100 so as to form the back drilling holes 102, the metallized through hole after back drilling forms the via structure 200, and the remaining part of the first through hole after back-drilling forms the hole section 101.

In the circuit board disclosed in embodiments of the present application, the via structure 200 is formed by forming the hole section 101 and back drilling hole 102 communicated with each other, and disposing the metal layer on the inner wall of the hole section 101, and the back drilling hole 102 is formed by a back-drilling process, such that the back drilling hole 102 can reduce a via stub, thereby improving the via impedance to a certain extent. Furthermore, by filling the via structure 200 with the first filler 300 and filling the back drilling hole 102 with the second filler 400, wherein the dielectric constant of the second filler 400 is less than the dielectric constant of the circuit board body 100, the problem of low via impedance caused by the dielectric constant of the second filler 400 being larger than the dielectric constant of the circuit board body 100 can be avoided, and compared to a circuit layer connected thereto, the via impedance is further increased, the high-frequency return loss and insertion loss are improved, and the signal integrity and transmission structure bandwidth are enhanced.

In order to further increase the via impedance, optionally, the dielectric constant of the first filler 300 may be equal to the dielectric constant of the second filler 400. Since the dielectric constant of the second filler 400 is less than the dielectric constant of the circuit board body 100, the dielectric constant of the first filler 300 is also less than the dielectric constant of the circuit board body 100.

In another embodiment, the dielectric constant of the first filler 300 may be greater than the dielectric constant of the second filler 400 and less than the dielectric constant of the circuit board body 100.

The circuit board disclosed in embodiments of the present application utilizes a first filler 300 with the dielectric constant less than that of the circuit board body 100, so as to further increase the via impedance to a certain extent, which further improves high-frequency return loss and insertion loss, and improves signal integrity and transmission structure bandwidth. When the dielectric constant of the first filler 300 is equal to the dielectric constant of the second filler 400, the first filler 300 and the second filler 400 may be made of the same material, thereby facilitating simultaneous filling of the first filler 300 and the second filler 400, which can improve filling efficiency.

In a simpler and more effective embodiment, the second filler 400 may be air. Since the dielectric constant of air is approximately the same as that of vacuum, air has a low dielectric constant, thereby effectively increasing the via impedance.

In other embodiments, the first filler 300 and the second filler 400 may be materials such as resin, green oil, etc., the first filler 300 and the second filler 400 may also be other materials. With the provision that the dielectric constant of the material of the second filler 400 is less than the dielectric constant of the material of the circuit board body 100, the specific materials of the first filler 300 and the second filler 400 are not limited in embodiments of the present application.

In one specific embodiment, the circuit board may include a ball grid array region, the via structure 200 may be located in the ball grid array region and used to be electrically connected with a ball grid array package structure.

It should be noted that upon the condition that the circuit board includes ball grid array structures, the ball grid array structure may be disposed in the ball grid array package region, and the ball grid array structure is electrically connected to the via structure 200, such that the ball grid array structures may be in signal interconnection with other ball grid array structures or high-speed connectors or other elements by the means of the via structure 200.

Optionally, the circuit board may include a connector mounting region, the via structure 200 may be located in the connector mounting region and used to be electrically connected with a connector.

It should be noted that upon the condition that the circuit board includes a connector, the connector may be disposed in the connector mounting region, and the connector is electrically connected to the via structure 200, such that the connector may be in signal interconnection with other connectors or ball grid array structures or other elements by means of the via structure 200.

In one embodiment, there may be one via structure 200, for example, one via structure 200 may be used for single-ended layer transition of a circuit board, so as to implement signal interconnection between a plurality of circuit layers 500 in the circuit board.

In another embodiment, the circuit board may include at least two via structures 200, wherein two of the at least two via structures 200 may form a differential pair. For example, the differential pair may be used for layer transition of a differential signal.

In some cases, the circuit board may further include a circuit layer 500, the circuit layer 500 is disposed in the circuit board body 100, and the circuit layer 500 is electrically connected to the sidewall of the via structure 200, the sidewall of the via structure 200 refers to the metal layer that forms the via structure 200. In the circuit board disclosed in embodiments of the present application, by disposing the circuit layer 500 that is electrically connected to the sidewall of the via structure 200, the circuit layer 500 may be in signal interconnection with other circuit layers or other elements by the via structure 200.

In some cases, there may be a plurality of circuit layers 500, and the plurality of circuit layers 500 may be spaced apart along the through hole direction of the via structure 200. It should be noted that, upon the condition that there are a plurality of via structures 200, some of the plurality of circuit layers 500 may be electrically connected to one of the via structures 200, other circuit layers 500 may be electrically connected to other via structures 200, thereby enabling signal interconnection between the plurality of circuit layers 500 and between the circuit layers 500 and other elements.

In some cases, different regions of the circuit board body 100 need to be metal-isolated by means of metal so as to control the influence of electric fields, magnetic fields, electromagnetic waves, etc., between different regions. Optionally, the circuit board may further include a shielding layer 600, the shielding layer 600 may be disposed in the circuit board body 100, the shielding layer 600 may be provided with a clearance structure 601, the via structure 200 may be located in the clearance structure 601 and spaced apart from the shielding layer 600.

In the circuit board disclosed in embodiments of the present application, by disposing the shielding layer 600, different regions of the circuit board body 100 may be metal-isolated by the shielding layer 600, thereby preventing influence of electric fields, magnetic fields, electromagnetic waves, etc., between different regions.

It should be noted that the shielding layer 600 may be designed according to the specific design of the circuit board, and the embodiments of the present application does not limit the specific installation position of the shielding layer 600.

The circuit board disclosed in embodiments of the present application may further include a pad 700, the pad 700 may be used to constitute a pad pattern of the circuit board, i.e., a combination of pads designed for a particular component type. The pad 700 may be disposed on the first surface and connected to the via structure 200.

Optionally, the via structure 200 in the circuit board disclosed in embodiments of the present application may be a differential pair structure for a BGA or connector region in the pitch of 1.0 mm, in the pitch of 0.8 mm, etc.

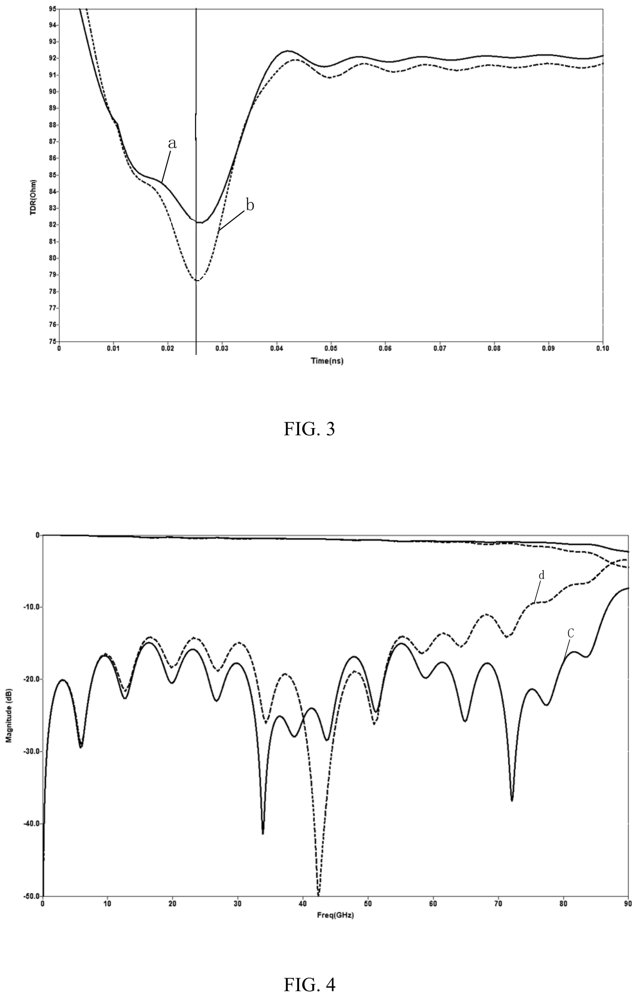

As shown in FIG. 3, FIG. 3 shows a comparison diagram of the via impedance of the circuit board disclosed in embodiments of the present application versus the via impedance of the circuit board in the related art, it can be seen from FIG. 3 that the via impedance of the circuit board in embodiments of the present application is increased by about 3.5 Ω with respect to the via impedance of the circuit board in the related art, which significantly improves the continuity of the via impedance of the circuit board.

In FIG. 3, "a" represents the via impedance in the circuit board disclosed in embodiments of the present application, while "b" represents the via impedance in the circuit board in the related art.

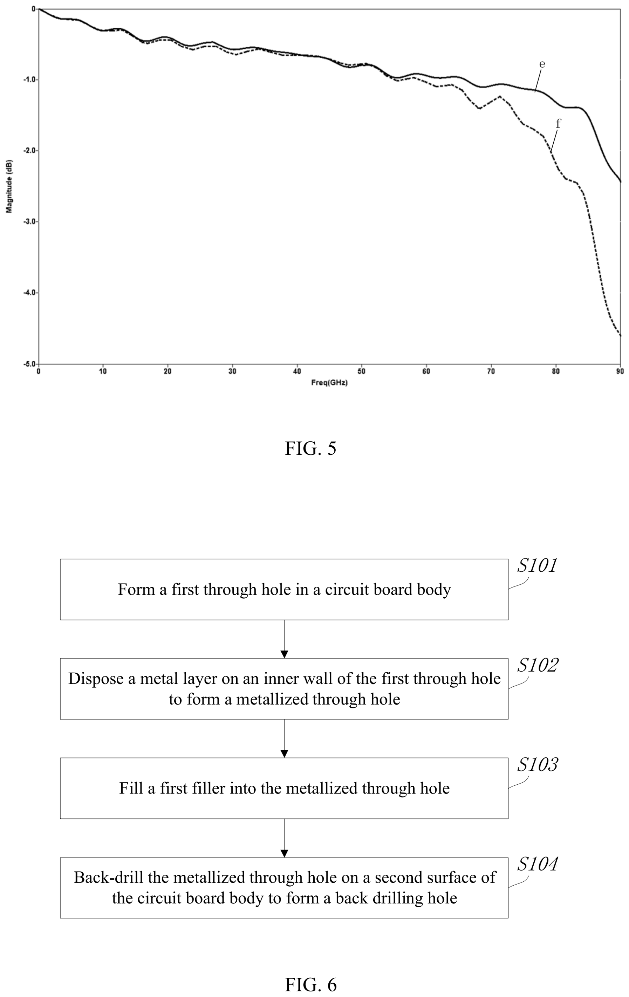

As shown in FIG. 4, FIG. 4 shows a comparison diagram of the insertion loss and return loss at the via structure in a circuit board disclosed in embodiments of the present application versus the insertion loss and return loss at the via structure in a circuit board i the related art, it can be seen from FIG. 4 that the return loss at the via structure 200 in the circuit board disclosed in embodiments of the present application is reduced by about 5~10 dB with respect to the return loss at the via structure in the circuit board of the related art. From the enlarged comparison diagram in FIG. 5 of the insertion loss of the circuit board disclosed in embodiments of the present application at the via structure 200 versus that at the via structure in the circuit board of the related art, it can be seen that the insertion loss at the via structure 200 in the circuit board disclosed in embodiments of the present application is improved by less than 5 dB with respect to the insertion loss at the via structure in the circuit board of the related art, which significantly improves the transmission bandwidth and signal integrity of the circuit board at the 1 the via structure 200, and improves the system margin.

In FIG. 4, "c" represents the return loss at the via structure 200 in the circuit board disclosed in embodiments of the present application, and "d" represents the return loss at the via structure in the circuit board in the related art. In FIG. 5, "e" represents the insertion loss at the via structure 200 in the circuit board disclosed in embodiments of the present application, and "f" represents the insertion loss at the via structure in the circuit board in the related art.

Therefore, the circuit board disclosed in embodiments of the present application has higher signal integrity at the via structure 200. Compared with the circuit boards in the related art, the circuit board disclosed in embodiments of the present application can effectively increase the via impedance, improve the signal integrity of the circuit board at the via structure 200, and increase the system margin.

The present application further discloses an electronic device, and the disclosed electronic device includes the circuit board disclosed in the above-mentioned embodiments.

According to the electronic device disclosed in embodiments of the present application, by including the circuit board disclosed in the above-mentioned embodiments, the electronic device can increase the via impedance of the circuit board, improve high-frequency return loss and insertion loss, and enhance signal integrity and transmission structure bandwidth.

In the embodiments of the present application, the electronic device may be a mobile phone, a tablet, a game console, a computer, etc., which are not limited in the embodiments of the present application.

The present application further discloses a manufacturing method for a circuit board, the disclosed circuit board includes a circuit board body 100, the disclosed manufacturing method of a circuit board includes the following steps.

At S101, a first through hole is formed in the circuit board body 100.

At S102, a metal layer is disposed on the inner wall of the first through hole so as to form a metallized through hole.

In some cases, the metal layer may be disposed on the inner wall of the first through hole by electroplating, or the metal layer may also be disposed on the inner wall of the first through holes in other manners, which is not limited in the present application.

At S103, a first filler 300 is filled into the metallized through hole.

At S104, the metallized through hole is back-drilled on a second surface of the circuit board body 100 so as to form a back drilling hole 102.

The metallized through hole after back drilling forms a via structure 200.

According to the circuit board manufactured by the manufacturing method for a circuit board disclosed in embodiments of the present application, the via impedance of the circuit board can be increased, high-frequency return loss and insertion loss can be improved, and signal integrity and transmission structure bandwidth can be enhanced.

Furthermore, after back-drilling the metallized through hole on the second surface of the circuit board body 100, the disclosed manufacturing method further includes:
Step A1, a second filler 400 is filled into the back drilling hole 102, where the dielectric constant of the second filler 400 is less than the dielectric constant of the circuit board body 100.

The present application further discloses a manufacturing method of a circuit board, the disclosed circuit board includes a circuit board body 100, the disclosed manufacturing method of a circuit board includes the following.

At Step B1, a first through hole is formed in the circuit board body 100.

At Step B2, a metal layer is disposed on the inner wall of the first through hole so as to form a metallized through hole.

At Step B3, the metallized through hole is back-drilled on a second surface of the circuit board body 100 so as to form a back drilling hole 102, wherein the metallized through hole after back drilling forms a via structure 200.

At Step B4, a first filler 300 is filled into the via structure 200, and a second filler 400 is filled into the back drilling hole 102.

The dielectric constant of the first filler 300 is greater than the dielectric constant of the second filler 400 and is less than the dielectric constant of the circuit board body 100.

According to the circuit board manufactured by the manufacturing method of a circuit board disclosed in embodiments of the present application, the via impedance of the circuit board can be increased, high-frequency return loss and insertion loss can be improved, and signal integrity and transmission structure bandwidth can be enhanced.

The above embodiments of the present application focus on description of differences among various embodiments, different optimized features from various embodiments can be combined to form more preferred embodiments so long as they are not contradictory, which will not be repeated here for the purpose of clarity.

The embodiments of the application are described above in conjunction with the accompanying drawings, but the application is not limited to the above-mentioned particular embodiments that are merely illustrative rather than limiting, a wide variety of forms can be made by a person skilled in the art under teachings of the application without departing from the spirit and scope of the application, and such forms all fall within the scope of the claims.

## Claims

1. A circuit board, comprising a circuit board body (100) and a via structure (200); the circuit board body (100) is provided with a hole section (101) and a back drilling hole (102) communicated with each other, a hole opening of the hole section (101) is located in a first surface of the circuit board body (100), a hole opening of the back drilling hole is located in a second surface of the circuit board body (100), the first surface and the second surface are opposite to each other, a metal layer is provided on an inner wall of the hole section (101) to form a via structure (200), the via structure (200) is filled with a first filler (300), the back drilling hole (102) is filled with a second filler (400), wherein a dielectric constant of the second filler (400) is less than a dielectric constant of the circuit board body (100).

2. The circuit board according to claim 1, wherein a dielectric constant of the first filler (300) is equal to the dielectric constant of the second filler (400).

3. The circuit board according to claim 1, wherein a dielectric constant of the first filler (300) is greater than the dielectric constant of the second filler (400) and is less than the dielectric constant of the circuit board body (100).

4. The circuit board according to claim 1, wherein the second filler (400) is air.

5. The circuit board according to claim 1, wherein the circuit board comprises a ball grid array region, and the via structure (200) is located in the ball grid array region and used to be electrically connected with a ball grid array package structure.

6. The circuit board according to claim 1, wherein the circuit board comprises a connector mounting region, and the via structure (200) is located in the connector mounting region and used to be electrically connected with a connector.

7. The circuit board according to claim 1, wherein the circuit board comprises at least two via structures (200), wherein two of the at least two via structures (200) form a differential pair.

8. The circuit board according to claim 1, wherein the circuit board further comprises a circuit layer (500), the circuit layer (500) is disposed in the circuit board body (100), and the circuit layer (500) is electrically connected to a sidewall of the via structure (200).

9. The circuit board according to claim 1, wherein the circuit board further comprises a shielding layer (600), the shielding layer (600) is disposed in the circuit board body (100), the shielding layer (600) is provided with a clearance structure (601), and the via structure (200) is located in the clearance structure (601) and spaced apart from the shielding layer (600).

10. An electronic device, comprising the circuit board according to any one of claims 1 to 9.

11. A manufacturing method for a circuit board, the circuit board comprising a circuit board body (100), the method comprises:
forming a first through hole in the circuit board body (100);
disposing a metal layer on an inner wall of the first through hole to form a metallized through hole;
filling a first filler (300) into the metallized through hole; and
back-drilling the metallized through hole on a second surface of the circuit board body (100) to form a back drilling hole (102), wherein the metalized through hole after back-drilling forms a via structure (200).

12. The manufacturing method according to claim 10, wherein after back-drilling the metallized through hole on the second surface of the circuit board body (100), the manufacturing method further comprises:
filling a second filler (400) into the back drilling hole (102), wherein a dielectric constant of the second filler (400) is less than a dielectric constant of the circuit board body (100).

13. A manufacturing method for a circuit board, the circuit board comprising a circuit board body (100), the method comprises:
forming a first through hole in the circuit board body (100);
disposing a metal layer on an inner wall of the first through hole to form a metallized through hole;
back-drilling the metallized through hole on a second surface of the circuit board body (100) to form a back drilling hole (102), wherein the metallized through hole after back drilling forms a via structure (200); and
filling a first filler (300) into the via structure (200), and filling a second filler (400) into the back drilling hole (102), wherein a dielectric constant of the first filler (300) is equal to a dielectric constant of the second filler (400) and is less than a dielectric constant of the circuit board body (100).
